# FASCICULE DE BREVET EUROPEEN

(11) **EP 2 420 117 B1**
(45) Date de publication et mention de la délivrance du brevet: **20.03.2013**
(21) Numéro de dépôt: 10713187.2
(22) Date de dépôt: 06.04.2010
(51) Int. Cl.: H05K 7/20, H01L 23/40

(54) **BOÎTIER POUR CARTE ÉLECTRONIQUE EMBARQUÉE**
GEHÄUSE FÜR ONBOARD ELEKTRONIK
HOUSING FOR ONBOARD ELECTRONICS

(30) Priorité: 14.04.2009 FR 0952450
(43) Date de publication de la demande: 22.02.2012
(73) Titulaire: European Aeronautic Defence And Space Company Eads France, 75016 Paris (FR)
(72) Inventeur: ASPAS PUERTOLAS, Jesus, F-75007 Paris (FR); MAISONNAVE, Nicolas, F-75014 Paris (FR); COLONGO, Emile, F-31310 Montesquieu Volvestre (FR); BOURDOU, Sylvain, F-33600 Pessac (FR)
(74) Mandataire: Fourcade, Emmanuelle
(86) Numéro de dépôt international: PCT/EP2010/054553
(87) Numéro de publication internationale: WO 2010/118971

(56) Documents cités:
- EP-A1- 1 248 507
- EP-A1- 1 791 177
- EP-A2- 1 689 220
- DE-A1- 10 206 271
- JP-A- 2005 116 650
- US-B1- 6 673 998

## Description

La présente invention relève du domaine de l'avionique. Plus précisément, elle concerne un boîtier pour cartes électroniques embarquées sur aéronefs.

De façon connue, pour améliorer leurs performances, leur sécurité, leur confort, leur automatisation etc., les aéronefs actuels embarquent de plus en plus d'équipements dont le contrôle est assuré par des cartes électroniques.

Celles-ci doivent alors être mécaniquement solidarisées à la structure de l'aéronef et répondre à diverses contraintes de sécurité normalisées (protection contre les chocs et poussières, réponse aux efforts mécaniques, contraintes de dissipation thermique ou de tenue à une plage de températures donnée, contraintes de tenue aux champs électromagnétiques, etc.).

Comme on le sait, les performances de l'électronique sont en amélioration constante, entre autres du fait de l'augmentation de la puissance des composants (processeurs en particulier). Cette évolution se traduit sous forme de chaleur dissipée de plus en plus importante (plusieurs dizaines de watts par carte électronique), nécessitant des moyens de dissipation thermique dédiés aux cartes électroniques embarquées, par exemple : dissipateurs passifs de type radiateur ou actif de type ventilateur ou caloduc.

Pour des raisons évidentes de sécurité de fonctionnement de l'aéronef en vol, ces cartes électroniques doivent enfin autant que possible supporter, au moins temporairement, une panne de ventilation sans compromettre la sécurité du vol.

Actuellement, la solution retenue est d'utiliser des boîtiers électroniques comportant environ cinq à dix cartes électroniques fixées à la structure. La dissipation de la chaleur est assurée par des dissipateurs en aluminium ou cuivre, fixés sur les processeurs les plus dissipatifs, et reliés à la structure métallique du boîtier, le plus souvent réalisée en aluminium. Cette liaison mécanique permet la conduction thermique et le refroidissement des processeurs.

Dans cette configuration, une panne d'une des cartes se traduit le plus souvent par le démontage et le remplacement du calculateur concerné, dont le coût peut atteindre plusieurs centaines de milliers d'euros.

De plus, les technologies de fabrication de boîtiers électroniques embarqués en aluminium atteignent leurs limites en termes d'efficacité de dissipation thermique et de poids tout en respectant des contraintes d'environnement électromagnétique et mécanique.

On comprend que l'augmentation incessante de puissance des processeurs va rendre ces boîtiers actuels incompatibles avec les normes de dissipation thermique et de sécurité.

L'objectif de cette invention est de faciliter la prise en compte des contraintes thermiques de plus en plus grandes auxquelles fait face l'électronique embarquée sur un aéronef.

Un autre objectif est de faciliter la maintenance et l'évolutivité des systèmes électroniques.

Un troisième objectif est de permettre de répartir l'électronique en divers points de l'aéronef, au lieu de concentrer toutes les cartes dans le même calculateur.

A cet effet, l'invention concerne un boîtier pour au moins une carte électronique comportant des composants thermiquement dissipatifs principalement sur une face dite supérieure, le boîtier étant de type présentant une largeur standardisée et comportant deux guides latéraux adaptés à venir coopérer avec des glissières ménagées sur les faces intérieures d'une baie électronique,
comprenant deux demi-coques, supérieure et inférieure, plaquées l'une contre l'autre au niveau des guides latéraux,
la demi-coque inférieure comportant au moins une zone d'appui formant le logement de la carte électronique,
le boîtier comprenant en outre des moyens de plaquer chaque carte électronique dans chaque logement correspondant, et de plaquer au moins un dissipateur thermique contre la face supérieure d'au moins une carte électronique,
le bâti ayant pour fonction la prise en compte des contraintes mécaniques liées aux cartes électroniques hébergées par le boîtier, et le capot ayant pour fonction d'assurer une bonne conductivité thermique permettant la dissipation de la chaleur produite par une carte électronique en cours de fonctionnement.

Selon un mode préféré de réalisation, les guides latéraux sont formés chacun d'une demi-guide supérieur faisant partie au capot, et d'un demi-guide inférieur faisant partie au bâti

Préférentiellement, le moyen de plaquage est un ressort venant prendre appui, d'une part, sur la face intérieure du capot, d'autre part, sur la carte électronique, enfin, sur un dissipateur afin de plaquer celui-ci sur au moins un composant fortement dissipatif de la carte électronique.

Dans ce cas, le ressort de plaquage est avantageusement constitué d'une bande rectangulaire périmétrique, destinée à venir se placer sous la face intérieure du capot, de pattes inclinées placées au vis à vis de chaque point d'appui du bâti solidarisées en leur partie haute à la bande rectangulaire périmétrique, d'un ensemble de bandes inclinées, solidarisées en leur partie haute à la bande rectangulaire périmétrique et destinées à transmettre une force d'appui sur la face supérieure d'un dissipateur thermique.

Préférentiellement, le dispositif de plaquage est réalisé en matériau présentant de très bonnes qualités de conductivité thermique.

Selon un mode préféré de réalisation du boîtier, le bâti est réalisé en matériau thermoplastique haute température.

Ce matériau thermoplastique haute température est par exemple du (Poly-Ether-Ether-Cétone) chargé en fibres courtes.

Avantageusement, le bâti est métallisé en surface.

Selon un mode préféré de réalisation du boîtier, le capot comprend un flan en matériau composite à très forte conductivité thermique, plié sur les bords pour épouser la forme du bâti.

Avantageusement, le capot comporte sur ses bords latéraux deux inserts métalliques formant chacun le demi-guide supérieur du boîtier, servant à assurer une bonne conduction thermique et électrique entre le capot et la baie électronique.

Préférentiellement, le capot comprend un moyen de protection électromagnétique.

Ce moyen de protection électromagnétique est par exemple un feuillard métallisé relié au matériau métallique formant les inserts métalliques.

Dans ce cas, le capot est réalisé par un processus comprenant une phase de drapage des couches de fibres et du feuillard métallisé sur une préforme, un assemblage avec les inserts métalliques, puis une cuisson par moyen chaud.

Pour permettre le passage de dissipateurs thermiques de grande hauteur, le capot comporte avantageusement sur sa face supérieure au moins un évidement rectangulaire adapté au passage d'au moins un dissipateur thermique.

Selon un mode préféré de réalisation du boîtier, le bâti et le capot ont des épaisseurs significativement différentes : l'espace disponible b dans le boîtier sous la carte électronique étant sensiblement inférieur à l'espace disponible a au dessus de celle-ci.

La description qui va suivre, donnée uniquement à titre d'exemple d'un mode de réalisation de l'invention, est faite en se référant aux figures annexées dans lesquelles :
la figure 1 est une vue en perspective d'un boîtier électronique selon l'invention,
la figure 2 illustre une vue en coupe de ce même boîtier,
la figure 3 est un schéma de principe de ce boîtier,
la figure 4 est une vue en perspective d'un module dont le capot a été retiré,
la figure 5 montre en vue en perspective de dessus un capot doté de dispositifs de plaquage et d'un dissipateur thermique,
la figure 6 illustre les mêmes éléments, en vue de dessous,
la figure 7 montre en perspective une baie électronique adaptée à accueillir des boîtiers selon l'invention,
la figure 8 illustre de même un exemple de mise en oeuvre des boîtiers électroniques selon l'invention dans une baie électronique embarquée sur avion,

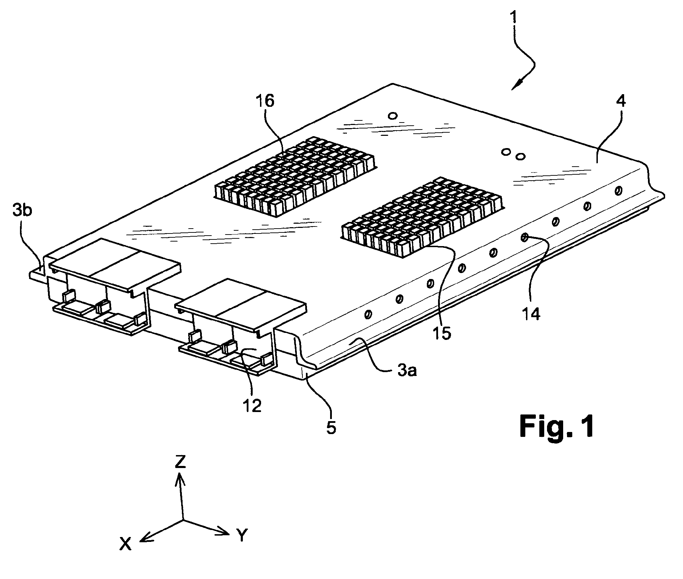

Le dispositif selon l'invention est un boîtier 1 globalement rectangulaire mince (voir figure 1), destiné à accueillir une ou plusieurs cartes électroniques 2 (non visibles sur la figure 1, qui illustre un boîtier fermé, tel que prêt à être intégré dans une baie électronique). Dans l'exemple décrit ici à titre nullement limitatif, le boîtier accueille deux cartes électroniques côte à côte. Les cartes électroniques dont il est ici question comportent la plupart de leurs composants sur une même face de la carte, dite face supérieure.

Un tel boîtier présente typiquement des dimensions d'environ vingt centimètres de long, quinze centimètres de large et deux d'épaisseur. Elles dépendent ici des dimensions existantes entre les glissières de baies électroniques de type standard en avionique.

Ce boîtier 1 est doté sur deux de ses faces latérales opposées de guides latéraux 3a, 3b, aptes à coopérer avec des glissières d'une baie électronique, non détaillée ici. Ces guides latéraux 3a, 3b sont des surfaces planes de largeur constante s'étendant perpendiculairement aux faces qui les supportent, et situées dans un plan parallèle au plan médian du boîtier 1.

On définit pour la suite de la description un axe longitudinal X, correspondant à la direction de ces guides latéraux 3a, 3b. De même, on définit un axe transversal Y perpendiculaire à ces guides latéraux 3a, 3b, et situé dans le plan principal du boîtier 1. Enfin un axe vertical Z complète ce repère.

Comme on le voit sur la figure 1, le boîtier 1 est formé principalement de deux parties : un capot 4 et un bâti 5. Ce bâti 5 et ce capot 4 se rejoignent latéralement au niveau des guides 3a, 3b, dont ils forment chacun la moitié environ de l'épaisseur.

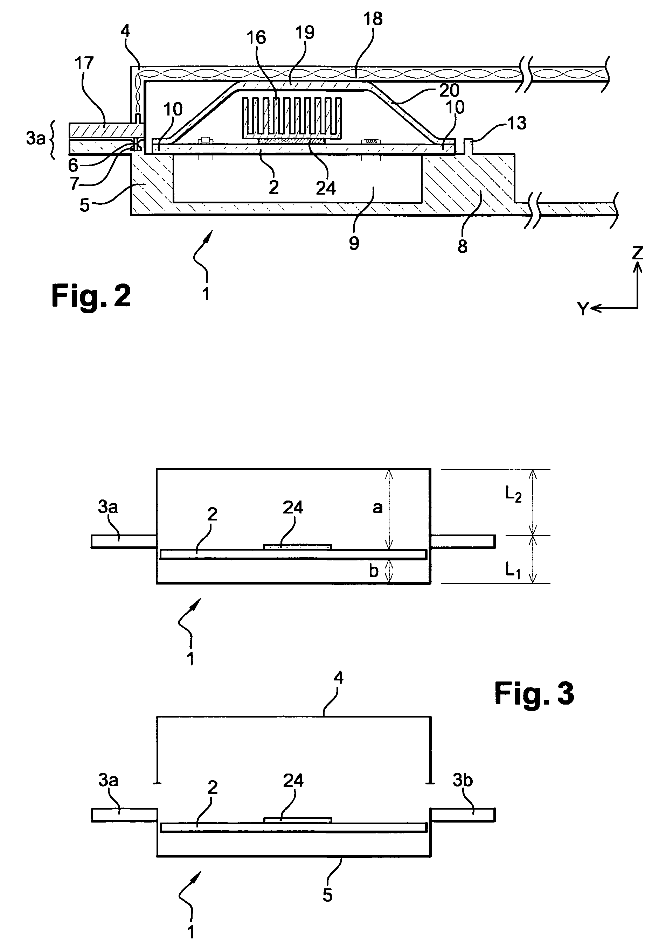

Le capot 4 vient se placer sur le bâti 5, le positionnement correct étant assuré par des ergots 6 (figure 2) disposés sous les bords latéraux du capot 4, et correspondant à des logements au sein des bords latéraux du bâti 5. Tel qu'illustré figure 2, ces ergots 6 et logements 7 sont ménagés sensiblement au niveau des guides latéraux 3a, 3b, formés chacun d'un demi-guide supérieur appartenant au capot 4, et d'un demi-guide inférieur appartenant au bâti 5.

Les ergots 6 peuvent alternativement être remplacés par des saillies longitudinales et les logements 7 par des glissières leur correspondant.

La disposition du boîtier 1 en deux éléments 4, 5 se superposant au niveau des guides latéraux 3a, 3b permet un montage du boîtier 1 sans utilisation de vis, le bâti 5 et le capot 4 étant plaqués l'un contre l'autre dès lors que les guides latéraux 3a, 3b sont insérés dans des glissières d'une baie électronique. Cette disposition facilite naturellement la maintenance de ces boîtiers.

Le bâti 5 a une fonction de prise en compte des contraintes mécaniques liées aux cartes électroniques 2 hébergées par le boîtier 1. Il a comme seconde fonction le positionnement correct desdites cartes 2.

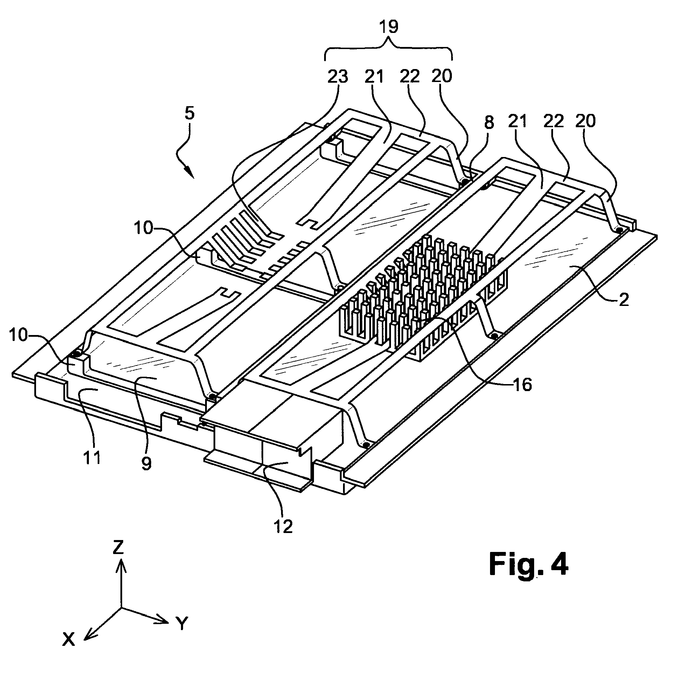

En conséquence, le bâti 5 (voir figure 2 et figure 4) se présente comme une coque rigide d'épaisseur sensiblement constante de un a trois millimètres ici séparée, par une paroi centrale 8, en deux logements longitudinaux évidés 9, destiné chacun à accueillir une carte électronique 2. Les bords longitudinaux et latéraux du bâti 5, ainsi qu'une butée centrale 13 (figure 2) limitent le jeu latéral résiduel d'une carte électronique 2 une fois placée dans son logement.

Chaque logement longitudinal évidé 9 comporte un ensemble de points d'appui 10 (trois de chaque côté longitudinal du logement 9 dans le cas illustré figure 4).

Le bâti 5 présente sur une de ses extrémités longitudinales un percement 11 principalement rectangulaire, face à chaque logement de carte électronique 2, adapté à permettre l'installation d'un connecteur 12 fixé au bout de la carte électronique 2. Ces connecteurs 12 sont de type standard, et le percement 11 est dimensionné en conséquence.

Pour des raisons de coût de fabrication réduit, et de capacité à prendre en compte les contraintes de géométrie (logement, paroi centrale, points d'appuis, percement etc.), le bâti 5 est fabriqué par moulage par injection à haute pression d'une matière plastique technique, par exemple un matériau thermoplastique de type PEEK (Poly-Ether-Ether-Cétone), chargé dans le présent exemple de fibres courtes, d'une façon connue en soi, pour améliorer sa conductivité thermique.

Le matériau de type PEEK choisi pour le bâti 5 ne présente pas nécessairement de très bonnes propriétés thermiques ou électriques, par contre il est très facile à travailler pour créer les sculptures souhaitées dans le bâti 5, peu coûteux et relativement léger malgré ses bonnes performances de résistance mécanique. Il est adapté à une production en série du bâti 5.

Ce bâti 5 reçoit une métallisation de surface pour améliorer ses propriétés de barrière électromagnétique et de masse électrique. Les procédés de fabrication du bâti 5 par moulage de matière thermoplastique et de métallisation sont connus de l'homme de l'art et ne sont donc pas détaillés plus avant ici.

Le capot 4 a, contrairement au bâti 5, pour fonction d'assurer une bonne conductivité thermique permettant la dissipation de la chaleur produite par une carte électronique 2 en cours de fonctionnement. De plus, ce capot 4 doit assurer une excellente protection électromagnétique des cartes électroniques 2. Par contre, sa forme géométrique est volontairement choisie simple, et le capot 4 n'a pas de fonction de transmission des efforts mécaniques entre les cartes électroniques 2 et la baie électronique.

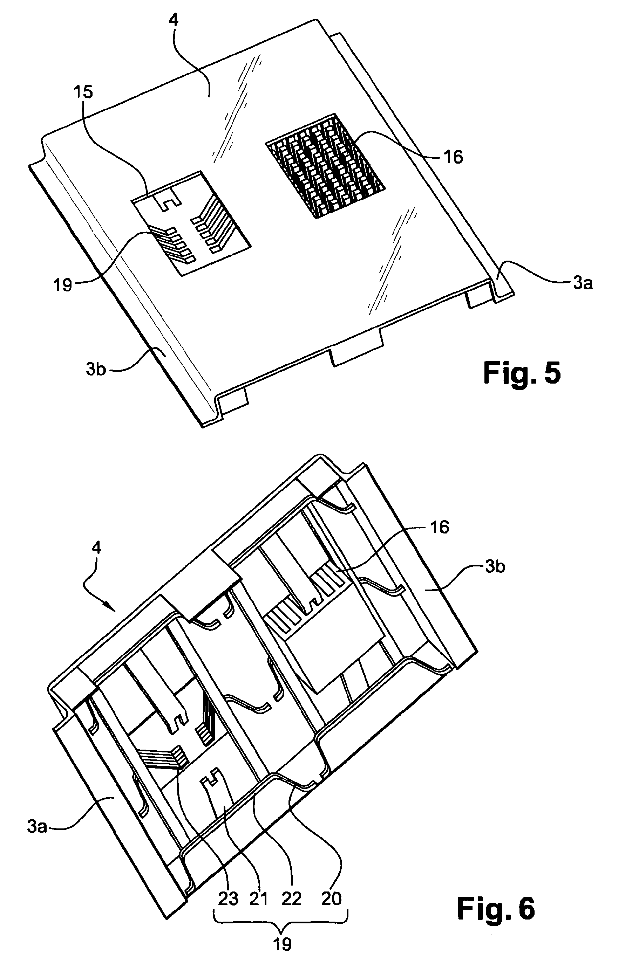

En conséquence, le capot 4 (voir figures 5 et 6) est composé principalement d'un flan en matériau composite, d'épaisseur quasiment constante (ici environ un millimètre), plié sur les bords pour épouser la forme rectangulaire du bâti 5. Il comporte sur chaque face latérale un ensemble de perçages 14 (voir figure 1) permettant une ventilation de l'intérieur du boîtier 1.

Par ailleurs, il comporte sur une de ses faces longitudinales un évidement permettant le passage des connecteurs 12.

En outre, le capot 4 peut comporter sur sa face supérieure deux évidements rectangulaires 15 adaptés au passage de dissipateurs thermiques 16, par exemple ici de type connu à socle plan et matrice d'excroissance verticales rectangulaires allongées.

Le capot 4 comporte sur ses bords latéraux deux inserts métalliques 17 formant chacun le demi-guide supérieur du boîtier 1. Ces inserts métalliques 17, réalisés par exemple en aluminium, servent à assurer une bonne conduction thermique et électrique entre le capot 4 et la baie électronique.

En dehors de ces inserts métalliques 17, le capot 4, qui doit présenter des qualités de conductivité thermique élevées, est réalisé sous forme d'un stratifié incluant une fibre de carbone graphitée possédant des propriétés thermiques de 800 W/mK, et un feuillard métallisé 18. Ce matériau présente une conductivité thermique supérieure à celle du cuivre. Cependant, sa mise en oeuvre est difficile, ce qui conduit en général à proscrire ce matériau pour des applications nécessitant une production en série.

Le feuillard métallisé 18 permet une protection électromagnétique des cartes électroniques 2 embarquées. Il est relié au matériau métallique formant les inserts métalliques 17.

Le capot 4 est, dans le présent exemple, réalisé par un processus associant un drapage des couches de fibres et du feuillard métallisé 18 sur une préforme, un assemblage avec les inserts métalliques 17, puis une cuisson par moyen chaud.

Le dispositif selon l'invention tire parti du fait que les cartes électroniques sont naturellement asymétriques, avec leurs composants généralement disposés sur une seule face, et donc un besoin d'espace et de volume de dissipation thermique nettement plus élevé sur une face que sur l'autre. De ce fait, l'espace disponible b dans le boîtier sous la carte électronique est sensiblement inférieur à l'espace disponible a au dessus de celle-ci, et par voie de conséquence, l'épaisseur L1 du bâti 5 est nettement inférieure à celle L2 du capot 4 (figure 3).

Le boîtier 1 selon l'invention comprend enfin, pour une ou plusieurs des cartes électroniques 2 hébergées dans le boîtier 1, un dispositif de plaquage 19 d'un dissipateur 16 sur un composant 24 (de type processeur) d'une carte électronique 2 hébergée dans le boîtier 1.

Ce dispositif de plaquage 19 (visible en deux exemplaires sur la figure 4) constitue en fait un ressort venant prendre appui :
d'une part, sur la face inférieure du capot 4, dans le présent exemple de mise en oeuvre, par une bande rectangulaire périmétrique 22,
d'autre part, sur la carte électronique 2, ici par des pattes inclinées 20 placées au vis à vis de chaque point d'appui 10 du bâti 5, solidarisées en leur partie haute à la bande rectangulaire périmétrique,
enfin, sur la partie supérieure du socle d'un dissipateur 16, ici par deux bandes 21 très inclinées, partant des bords longitudinaux de la bande rectangulaire périmétrique 22 et deux séries de pattes inclinées 23, partant des bords latéraux de la bande rectangulaire périmétrique 22.

Le dispositif de plaquage 19 est naturellement ici décrit dans le cas de dissipateur 16 de type à socle plan et matrice d'excroissances verticales rectangulaires allongées.

Le dispositif de plaquage 19 est également réalisé en matériau très bon conducteur thermique.

La mise en oeuvre du boîtier selon l'invention est très aisée et rapide : après la mise en place d'une carte électronique 2 (comportant un processeur dans sa zone centrale) sur les points d'appui 10 d'un logement 9 du bâti 5, un dissipateur 16 est placé sur le processeur 24, puis le dispositif de plaquage 19 est placé sur le dissipateur 16, enfin le capot 4 est disposé au dessus du dispositif de plaquage 19, en laissant passer la partie supérieure du dissipateur 16 au travers des évidements 15 prévus à cet effet.

On comprend que la seule fonction mécanique du capot 4 est d'assurer le plaquage correct du dissipateur 16 et de la carte électronique 2 dans son logement au sein du bâti 5.

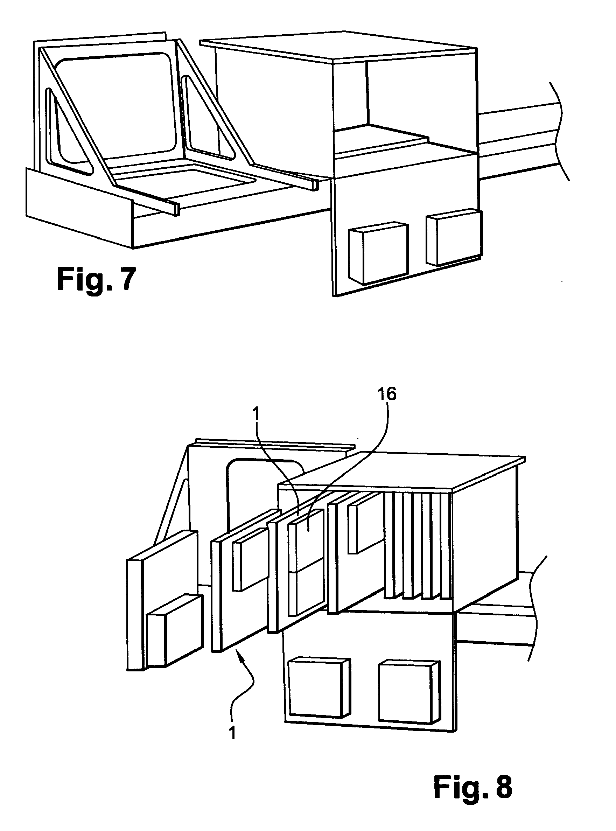

Le boîtier 1 complet est ensuite inséré par glissement des guides latéraux 3a, 3b dans des glissières d'une baie électronique compatible, jusqu'à ce que les connecteurs 12 soient en contact avec un connecteur correspondant assurant la continuité électrique et de données (figures 7 et 8). Un ensemble de boîtiers électroniques similaires (huit boîtiers 1 dans l'exemple illustré figure 6, sur lequel les ventilateurs de réfrigération 16 sont nettement visibles)est ainsi intégré dans une baie électronique disposée sur une étagère d'équipements avion.

En fonctionnement, un ensemble de ventilateurs vient fournir un refroidissement des boîtiers par renouvellement permanent d'air. Dans ce cas , plus de 80% du refroidissement des cartes électroniques est assuré par convection.

Cependant, au contraire, en cas de panne de ces ventilateurs, ce qui constitue un cas dimensionnant d'un point de vue sécurité de vol, 80% du refroidissement doit être assuré par conduction.

Dans le présent dispositif, le dissipateur 16 plaqué sur le processeur 24, forme une continuité thermique avec le dispositif de plaquage 19, le capot 4, et la baie électronique, il assure ainsi, en conjonction avec le capot 4, excellent conducteur thermique, un refroidissement correct de la carte électronique 2.

Par rapport aux dispositifs antérieurs, la conduction thermique entre les composants dissipatifs et la baie électronique est ici assurée par le ressort de plaquage et le capot du boîtier, fournissant ainsi une grande surface de conduction thermique, nettement supérieure aux boîtiers existants.

Le présent dispositif présente également l'avantage de ne pas nécessiter de vis pour la fixation des cartes électroniques 2, dissipateurs 16 ou capot 4 du boîtier 1, ce qui simplifie la maintenance et, par exemple, le remplacement d'une carte électronique.

La portée de la présente invention ne se limite pas aux détails des formes de réalisation ci-dessus considérées à titre d'exemple, mais s'étend au contraire aux modifications à la portée de l'homme de l'art.

Dans la description qui précède, le dissipateur thermique traverse le capot. Il est clair que selon le type de dissipateur thermique utilisé, il n'est pas nécessaire de prévoir cette traversée du capot.

Plus généralement, le boîtier tel que décrit est modulaire, et il est facile de modifier le type de capot utilisé pour un boîtier, voire d'utiliser des dispositifs de plaquage adaptés à diverses positions des composants dissipatifs sur la carte électronique.

Dans une variante de réalisation, le matériau à haute qualité de conductivité thermique est un composite à matrice métallique (nanotubes de carbone + aluminium).

La description de l'invention présente le cas de cartes électroniques dont les composants actifs sont disposés sur une seule face. Dans le cas de cartes à deux faces dissipatives, le présent dispositif, conçu pour avoir d'une part un moyen de maintien mécanique de la carte, et de l'autre un moyen de conduction thermique, reste applicable dans son principe.

Dans ce cas, le moyen de tenue mécanique de la carte est un cadre solidarisé à la carte électronique par ses bords, et le boîtier comporte deux capots dissipatifs, placés de part et d'autre de la carte électronique, tout en prenant appui sur le bâti central.

## Revendications

1. Boîtier (1) pour au moins une carte électronique (2) comportant des composants thermiquement dissipatifs principalement sur une face dite supérieure, le boîtier étant de type globalement rectangulaire mince, présentant une largeur standardisée et comportant deux guides latéraux (3a, 3b) adaptés à venir coopérer avec des glissières ménagées sur les faces intérieures d'une baie électronique,
comprenant deux demi-coques, supérieure (4), dite capot, et inférieure (5), dite bâti, plaquées l'une contre l'autre au niveau des guides latéraux,
le bâti (5) comportant au moins une zone d'appui (10) formant logement de carte électronique, et des premiers moyens (19) de plaquer au moins un dissipateur thermique (16) contre la face supérieure d'au moins une carte électronique (2),
**caractérisé en ce que**
- le boîtier (1) comprend en outre des seconds moyens (19) de plaquer sans vissage chaque carte électronique (2) dans chaque logement correspondant, et
- le bâti comporte des moyens de prise en compte des contraintes mécaniques liées aux cartes électroniques (2) hébergées par le boîtier (1) et des moyens de positionnement correct (8, 9, 10, 13) desdites cartes (2), limitant le jeu latéral résiduel d'une carte électronique (2) une fois placée dans son logement.
- les premier et second moyens de plaquage sont constitués d'un même dispositif de plaquage (19) prenant appui, d'une part, sur la face inférieure du capot (4), d'autre part sur la carte électronique (2), enfin, sur la partie supérieure du dissipateur thermique (16),
- le dispositif de plaquage (19) est réalisé en matériau présentant de très bonnes qualités de conductivité thermique,
- le capot (4) comprend un flan en matériau à très forte conductivité thermique.

2. Boîtier selon la revendication 1, **caractérisé en ce que** les guides latéraux (3a, 3b) sont formés chacun d'un demi-guide supérieur faisant partie du capot (4), et d'un demi-guide inférieur faisant partie au bâti (5).

3. Boîtier selon l'une quelconque des revendications précédentes, **caractérisé en ce que** le moyen de plaquage (19) est un ressort venant prendre appui, d'une part, sur la face intérieure du capot (4), d'autre part, sur la carte électronique (2), enfin, sur un dissipateur (16) afin de plaquer celui-ci sur au moins un composant fortement dissipatif de la carte électronique (2).

4. Boîtier selon la revendication 3, **caractérisé en ce que** le ressort de plaquage est constitué d'une bande rectangulaire périmétrique (22), destinée à venir se placer sous la face intérieure du capot (4), de pattes inclinées (20) placées au vis à vis de chaque point d'appui (10) du bâti (5) solidarisées en leur partie haute à la bande rectangulaire périmétrique, d'un ensemble de bandes (21) inclinées, solidarisées en leur partie haute à la bande rectangulaire périmétrique (22) et destinées à transmettre une force d'appui sur la face supérieure d'un dissipateur thermique (16).

5. Boîtier selon l'une quelconque des revendications précédentes, **caractérisé en ce que** le bâti (5) est réalisé en matériau thermoplastique haute température.

6. Boîtier selon la revendication 5, **caractérisé en ce que** le matériau thermoplastique haute température est du (Poly-Ether-Ether-Cétone) chargé en fibres courtes.

7. Boîtier selon l'une quelconque des revendications 5 à 6, **caractérisé en ce que** le bâti (5) est métallisé en surface.

8. Boîtier selon l'une quelconque des revendications précédentes, **caractérisé en ce que** le capot (4) comporte sur ses bords latéraux deux inserts métalliques (17) formant chacun le demi-guide supérieur du boîtier (1), servant à assurer une bonne conduction thermique et électrique entre le capot (4) et la baie électronique.

9. Boîtier selon l'une quelconque des revendications précédentes, **caractérisé en ce que** le capot (4) comprend un moyen de protection électromagnétique.

10. Boîtier selon la revendication 9, **caractérisé en ce que** le moyen de protection électromagnétique est un feuillard métallisé (18) relié au matériau métallique formant les inserts métalliques (17).

11. Boîtier selon la revendication 10, **caractérisé en ce que** le capot (4) est réalisé par un processus comprenant une phase de drapage des couches de fibres et du feuillard métallisé (18) sur une préforme, un assemblage avec les inserts métalliques (17), puis une cuisson par moyen chaud.

12. Boîtier selon l'une quelconque des revendications précédentes, **caractérisé en ce que** le capot (4) comporte sur sa face supérieure au moins un évidement rectangulaire (15) adapté au passage d'au moins un dissipateur thermique (16).

13. Boîtier selon l'une quelconque des revendications précédentes, **caractérisé en ce que** le bâti (5) et le capot (4) ont des épaisseurs significativement différentes : l'espace disponible b dans le boîtier (1) sous la carte électronique (2) étant sensiblement inférieur à l'espace disponible a au dessus de celle-ci.

14. Boîtier selon l'une quelconque des revendications précédentes, **caractérisé en ce que** le matériau à haute qualité de conductivité thermique constituant le dispositif de plaquage (19) est un composite à matrice métallique de type nanotubes de carbone + aluminium.

15. Boîtier selon l'une quelconque des revendications précédentes, **caractérisé en ce que** le matériau à haute qualité de conductivité thermique constituant le capot (4) est un stratifié incluant une fibre de carbone graphitée possédant une conductivité thermique supérieure à celle du cuivre.

## Claims

1. A case (1) for at least one electronic board (2) comprising thermally dissipative components principally on a face known as higher, the case being a generally rectangular thin type, displaying a standardised width and comprising two side guides (3a, 3b), adapted to collaborate with provided runners on the interior faces of an electronics rack,
including two half shells, higher (4), known as cowling, and lower (5), known as mount, pressed against each other on the level of the side guides,
the mount (5) comprising at least one support area (10) forming an electronic board compartment, and first means (19) of pressing at least one thermal sink (16) against the higher face of at least one electronic board (2),
**characterised in that**
- the case (1) additionally includes second means (19) of pressing without screwing each electronic board (2) in each corresponding compartment, and
- the mount comprises means of taking into account the mechanical constraints linked to the electronic boards (2) accommodated by the case (1) and means of correct positioning (8, 9, 10, 13) of the said boards (2), limiting the residual side clearance of an electronic board (2) once placed in its compartment.
- the first and second means of pressing are made of a same pressing device (19) pressing, on the one hand, on the lower face of the cowling (4), on the other hand, on the electronic board (2), and finally on the higher part of the thermal sink (16),
- the pressing device (19) is made of material with very high levels of thermal conductivity,
- the cowling (4) includes a blank made of material with very strong thermal conductivity.

2. A case according to claim 1, **characterised in that** the side guides (3a, 3b) are each formed from a higher half-guide, being a part of the cowling (4), and from a lower half-guide, being a part of the mount (5).

3. A case according to one of any of the previous claims, **characterised in that** the pressing means (19) is a supporting spring, pressing, on the one hand, on the lower face of the cowling (4), on the other hand, on the electronic board (2), and finally on a sink (16), aiming to press this on at least one component highly dissipative of the electronic board (2).

4. A case according to claim 3, **characterised in that** the pressing spring is made of a rectangular perimeter band (22), meant to be placed under the lower face of the cowling (4), of inclining legs (20), placed against each support point (10) of the mount (5), connected in their high part to the rectangular perimeter band, of a set of inclining bands (21), connected in their high part to the rectangular perimeter band (22) and meant for giving a support strength on the higher face of a thermal sink (16).

5. A case according to one of any of the previous claims, **characterised in that** the mount (5) is made of high temperature thermoplastic material.

6. A case according to claim 5, **characterised in that** the high temperature thermoplastic material is (poly-ether-ether-ketone), filled with short fibres.

7. A case according to any of claims 5 to 6, **characterised in that** the mount (5) is metal-coated on the surface.

8. A case according to any of the previous claims, **characterised in that** the cowling (4) comprises two metallic inserts (17) on its side rims, each one forming the higher half-guide of the case (1), serving to ensure a good thermal and electrical conduction between the cowling (4) and the electronic rack.

9. A case according to any of the previous claims, **characterised in that** the cowling (4) includes an electromagnetic protection means.

10. A case according to claim 9, **characterised in that** the electromagnetic protection means is a metal-coated hoop (18), linked to the metallic material forming the metallic inserts (17).

11. A case according to claim 10, **characterised in that** the cowling (4) is made by a process including a phase of wrapping layers of fibres and the metal-coated hoop (18) on a pre-form, an assembly with metallic inserts (17), then conditioning by hot means.

12. A case according to any of the previous claims, **characterised in that** the cowling (4) comprises on the higher face, at least one rectangular blind hole (15), adapted to the passing of at least one thermal sink (16).

13. A case according to any of the previous claims, **characterised in that** the mount (5) and the cowling (4) have significantly different thicknesses: the available space b in the case (1) under the electronic board (2) being substantially less than the available space α above it.

14. A case according to any of the previous claims, **characterised in that** the material with high levels of thermal conductivity, making up the pressing device (19), is a composite of metallic matrix of the carbon + aluminium nanotubes type.

15. A case according to any of the previous claims, **characterised in that** the material with high levels of thermal conductivity, making up the cowling (4), is a laminate which includes a carbon graphite fibre, having a higher thermal conductivity to that of copper.

## Patentansprüche

1. Gehäuse (1) für zumindest eine Elektronikkarte (2), das vorwiegend auf der als Oberseite bezeichneten Seite Bauteile zur Ableitung der Wärme umfasst, wobei das Gehäuse im Allgemeinen dünn und rechteckig ist und eine standardisierte Breite, sowie zwei seitliche Führungen (3a, 3b) aufweist, die geeignet sind, in die Gleitschienen einzugreifen, die an den Innenseiten eines Elektronikracks angeordnet sind,
umfassend zwei Halbschalen, eine obere (4), die Abdeckung genannt wird, und eine untere (5), die Rahmen genannt wird, die im Bereich der seitlichen Führungen aneinandergefügt sind,
wobei der Rahmen (5) zumindest einen Auflagebereich (10) umfasst, der den Sitz für die Elektronikkarte bildet, sowie erste Mittel (19), um zumindest einen Wärmeableiter (16) auf die Oberseite zumindest einer Elektronikkarte (2) zu drücken,
**dadurch gekennzeichnet, dass**
- das Gehäuse (1) darüber hinaus zweite Mittel (19) zum schraubenlosen Andrücken jeder Elektronikkarte (2) in jeden entsprechenden Sitz umfasst, und
- das Gehäuse Mittel zur Berücksichtigung der mechanischen Belastungen im Zusammenhang mit den Elektronikkarten (2) umfasst, die vom Gehäuse (1) aufgenommen werden, sowie Mittel zur korrekten Positionierung (8, 9, 10, 13) der besagten Karten (2), zur Begrenzung des verbleibenden seitlichen Spiels einer Elektronikkarte (2), sobald diese in ihrem Sitz angebracht ist,
- die ersten und zweiten Andrückmittel aus einer selben Andrückvorrichtung (19) gebildet werden, die einerseits an der Unterseite der Abdeckung (4) und andererseits an der Elektronikkarte (2), und schließlich auf dem oberen Abschnitt des Wärmeableiters (16) anliegt,
- die Andrückvorrichtung (19) aus einem Werkstoff gebildet wird, der sehr gute Wärmeleiteigenschaften aufweist,
- die Abdeckung (4) ein Blechplättchen aus einem Werkstoff mit sehr guter Wärmeleiteigenschaft umfasst.

2. Gehäuse nach Anspruch 1, **dadurch gekennzeichnet, dass** die seitlichen Führungen (3a, 3b) jeweils aus einer oberen Halbführung, die Teil der Abdeckung (4) ist, und aus einer unteren Halbführung, die Teil des Rahmens (5) ist, gebildet werden.

3. Gehäuse nach irgendeinem der vorherigen Ansprüche, **dadurch gekennzeichnet, dass** das Andrückmittel (19) eine Feder ist, die einerseits an der Innenseite der Abdeckung (4) und andererseits an der Elektronikkarte (2), und schließlich auf einem Ableiter (16) anliegt, um diesen zumindest auf ein stark ableitendes Bauteil der Elektronikarte (2) zu drücken.

4. Gehäuse nach Anspruch 3, **dadurch gekennzeichnet, dass** die Andrückfeder aus einem umlaufenden rechteckigen Band (22) gebildet wird, das dazu bestimmt ist, sich unter die Innenseite der Abdeckung (4) zu setzen, aus geneigten Laschen (20), die gegenüber jedem Auflagepunkt (10) des Rahmens (5) angeordnet, und in ihrem oberen Abschnitt fest mit dem umlaufenden rechteckigen Band verbunden sind, aus einer Reihe von geneigten Bändern (21), die in ihrem oberen Abschnitt fest mit dem umlaufenden rechteckigen Band (22) verbunden, und dazu bestimmt sind, eine Auflagekraft auf die Oberseite eines Wärmeableiters (16) zu übertragen.

5. Gehäuse nach irgendeinem der vorherigen Ansprüche, **dadurch gekennzeichnet, dass** der Rahmen (5) aus einem hochtemperaturbeständigen thermoplastischen Werkstoff gebildet wird.

6. Gehäuse nach Anspruch 5, **dadurch gekennzeichnet, dass** der hochtemperaturbeständige thermoplastische Werkstoff mit kurzen Fasern angereichertes (Polyetheretherketon) ist.

7. Gehäuse nach irgendeinem der Ansprüche 5 bis 6, **dadurch gekennzeichnet, dass** das Gehäuse an der Oberfläche metallisiert ist.

8. Gehäuse nach irgendeinem der vorherigen Ansprüche, **dadurch gekennzeichnet, dass** die Abdeckung (4) an ihren seitlichen Rändern zwei Metalleinsätze (17) umfasst, die jeweils die obere Halbführung des Gehäuses (1) bilden und dazu dienen, um für eine gute Temperatur- und Stromleitung zwischen der Abdeckung (4) und dem Elektronikrack zu sorgen.

9. Gehäuse nach irgendeinem der vorherigen Ansprüche, **dadurch gekennzeichnet, dass** die Abdeckung (4) eine elektromagnetische Schutzvorrichtung umfasst.

10. Gehäuse nach Anspruch 9, **dadurch gekennzeichnet, dass** die elektromagnetische Schutzvorrichtung ein metallisiertes Bandmaterial ist (18), das mit dem metallischen Werkstoff verbunden ist, der die Metalleinsätze (17) bildet.

11. Gehäuse nach Anspruch 10, **dadurch gekennzeichnet, dass** die Abdeckung (4) durch einen Prozess erzeugt wird, der eine Phase des Drappierens der Faserschichten und des metallisierten Bandmaterials (18) auf einen Rohling, ein Zusammensetzen mit den Metalleinsätzen (17) und ein Brennen mittels einer heißen Vorrichtung umfasst.

12. Gehäuse nach irgendeinem der vorherigen Ansprüche, **dadurch gekennzeichnet, dass** die Abdeckung (4) an ihrer Oberseite zumindest eine rechteckige Ausnehmung (15) umfasst, die sich zur Durchführung zumindest eines Wärmeableiters (16) eignet.

13. Gehäuse nach irgendeinem der vorherigen Ansprüche, **dadurch gekennzeichnet, dass** der Rahmen (5) und die Abdeckung (4) wesentlich unterschiedliche Dicken aufweisen: der im Gehäuse (1) unter der Elektronikkarte (2) verfügbare Raum b ist dabei etwas kleiner, als der verfügbare Raum *a*, der sich über selbiger befindet.

14. Gehäuse nach irgendeinem der vorherigen Ansprüche, **dadurch gekennzeichnet, dass** der Werkstoff mit der hohen Wärmeleitfähigkeit, aus dem die Andrückvorrichtung (19) gebildet wird, ein Verbundwerkstoff mit metallischer Matrix in der Art von Kohlenstoff-Nanoröhrchen + Aluminium ist.

15. Gehäuse nach irgendeinem der vorherigen Ansprüche, **dadurch gekennzeichnet, dass** der Werkstoff mit der hohen Wärmeleitfähigkeit, aus dem die Abdeckung (4) gebildet wird, ein Schichtstoff ist, in dem eine graphithaltige Karbonfaser eingearbeitet ist, die eine Wärmeleitfähigkeit aufweist, die höher als jene von Kupfer ist.
